# EUROPÄISCHE PATENTSCHRIFT

(11) **EP 3 341 795 B1**
(45) Veröffentlichungstag und Bekanntmachung des Hinweises auf die Patenterteilung: **23.03.2022**
(21) Anmeldenummer: 16753677.0
(22) Anmeldetag: 19.08.2016
(51) Int. Cl.: G03F 7/20, G02B 26/08, G01D 5/24

(54) **SENSORANORDNUNG FÜR EINE LITHOGRAPHIEANLAGE, LITHOGRAPHIEANLAGE UND VERFAHREN ZUM BETREIBEN EINER LITHOGRAPHIEANLAGE**
SENSOR ARRANGEMENT FOR A LITHOGRAPHY SYSTEM, LITHOGRAPHY SYSTEM, AND METHOD FOR OPERATING A LITHOGRAPHY SYSTEM
ENSEMBLE DE CAPTEURS POUR UNE INSTALLATION DE LITHOGRAPHIE, INSTALLATION DE LITHOGRAPHIE ET PROCÉDÉ DE FONCTIONNEMENT D'UNE INSTALLATION DE LITHOGRAPHIE

(30) Priorität: 27.08.2015 DE 102015216438
(43) Veröffentlichungstag der Anmeldung: 04.07.2018
(73) Patentinhaber: Carl Zeiss SMT GmbH, 73447 Oberkochen (DE)
(72) Erfinder: BIHR, Ulrich, 73467 Kirchheim (DE); HOLZ, Markus, 73431 Aalen (DE); HORN, Jan, 80639 München (DE)
(74) Vertreter: Horn Kleimann Waitzhofer Patentanwälte PartG mbB
(86) Internationale Anmeldenummer: PCT/EP2016/069688
(87) Internationale Veröffentlichungsnummer: WO 2017/032706

(56) Entgegenhaltungen:
- EP-A2- 0 840 092
- EP-A2- 2 687 906
- US-B1- 6 326 795

## Beschreibung

Die vorliegende Erfindung betrifft eine Sensoranordnung zum Erfassen einer Lage, Stellung und/oder Bewegung eines optischen Elements in einer Lithographieanlage, eine Lithographieanlage sowie ein Verfahren zum Betreiben einer Lithographieanlage. Mit Hilfe von Sensoren in einer Lithographieanlage kann beispielsweise die Lage oder Position von optischen Elementen, wie Spiegeln oder Linsen, erfasst werden.

Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat (z. B. ein Siliziumwafer) projiziert, um die Maskenstruktur auf die lichtempfindliche Beschichtung des Substrats zu übertragen.

Getrieben durch das Streben nach immer kleineren Strukturen bei der Herstellung integrierter Schaltungen werden derzeit EUV-Lithographieanlagen entwickelt, welche Licht mit einer Wellenlänge im Bereich von 0,1 nm bis 30 nm, insbesondere von 4 nm bis 6 nm, verwenden. Bei solchen EUV-Lithographieanlagen müssen wegen der hohen Absorption der meisten Materialien von Licht dieser Wellenlänge reflektierende Optiken, das heißt Spiegel, anstelle von - wie bisher - brechenden Optiken, das heißt Linsen, eingesetzt werden. Aus gleichem Grund ist die Strahlformung und Strahlprojektion in einem Vakuum durchzuführen.

Die Spiegel können z. B. an einem Tragrahmen (Engl.: force frame) befestigt und wenigstens teilweise manipulierbar oder verkippbar ausgestaltet sein, um eine Bewegung eines jeweiligen Spiegels in bis zu sechs Freiheitsgraden und damit eine hochgenaue Positionierung der Spiegel zueinander, insbesondere im pm-Bereich, zu ermöglichen. Somit können etwa im Betrieb der Lithographieanlage auftretende Änderungen der optischen Eigenschaften, z. B. infolge von thermischen Einflüssen, ausgeregelt werden.

Ferner werden Spiegel in Beleuchtungssystemen für Lithographieanlagen eingesetzt. Die eingesetzten Spiegel müssen dabei präzise positioniert werden und deren Lage oder Stellung erfasst werden. Zum Bewegen der Spiegel sind meist Aktuatoren vorgesehen, welche über einen Regelkreis angesteuert werden. Als Teil des Regelkreises ist dann häufig eine Vorrichtung zur Überwachung des Kippwinkels eines jeweiligen Spiegels mit Hilfe von Sensoren vorgesehen.

Beispielsweise ist aus der WO 2009/100856 A1 ein Facettenspiegel für eine Projektionsbelichtungsanlage einer Lithographieanlage bekannt, welche eine Vielzahl von individuell verlagerbaren Einzelspiegeln aufweist. Um die optische Qualität einer Projektionsbelichtungsanlage sicherzustellen, ist eine sehr präzise Erfassung und Positionierung der verlagerbaren Einzelspiegel notwendig. Das Dokument DE 10 2013 209 442 A1 beschreibt ferner, dass ein Feldfacettenspiegel als mikroelektromechanisches System (Micro-Electro-Mechanical System, MEMS) ausgebildet sein kann.

Das Dokument EP 2 687 906 A2 offenbart eine Steuereinrichtung zur Steuerung der Positionierung mindestens eines verlagerbaren Einzelspiegels, bei welcher eine Aktuatorelektrode auch als Sensorelektrode dient. Die Ansteuerung des Einzelspiegels erfolgt über ein Pulsweitenmodulationsschema.

Das Dokument EP 0 840 092 A2 offenbart eine Treiberelektronik für Mikroaktuatoren, bei der kammartige Mikroelektroden durch Einkoppeln eines Ansteuersignals in mechanische Schwingungen versetzt werden. Die Elektroden wirken gleichzeitig als Kondensatorelemente, mit denen eine Abweichung der mechanischen Schwingungen von ihrer Resonanzfrequenz erfasst werden kann.

Zur Lagebestimmung werden oft kapazitive Sensoreinrichtungen verwendet, die mit Hilfe von sogenannten "switched-capacitor" Ausleseschaltungen ausgelesen werden. Die bei der Ansteuerung der kapazitiven Sensorelemente notwendigen hohen Anregungsfrequenzen können jedoch zu einem ungünstigen Signalrauschverhältnis (SNR) bzw. Störabstand führen. Ursache dafür können beispielsweise parasitäre Kapazitäten oder Leitungswiderstände in der jeweiligen Sensoranordnung und deren Verschaltung sein. Es ist eher wünschenswert, hohe Anregungsfrequenzen für eine Ausleseschaltung verwenden zu können, wobei parasitäre Widerstände, Induktivitäten, und/oder parasitäre Kapazitäten als störend empfunden werden.

Vor diesem Hintergrund besteht eine Aufgabe der vorliegenden Erfindung darin, eine verbesserte Sensoranordnung und/oder Sensoransteuerung zu schaffen.

Demgemäß wird eine Sensoranordnung zum Verfassen einer Lage oder Position eines optischen Elementes in einer Lithographieanlage vorgeschlagen. Die Sensoranordnung umfasst dabei:
eine erste kapazitive Sensoreinrichtung, welche eine lageabhängige veränderbare erste Sensorkapazität hat, welche mit Hilfe eines ersten Anregungssignals erfassbar ist; und
eine zweite kapazitive Sensoreinrichtung, welche eine lageabhängige veränderbare zweite Sensorkapazität hat, welche mit Hilfe eines zweiten Anregungssignals erfassbar ist.

Die Sensoranordnung umfasst ferner eine Steuereinrichtung, welche eingerichtet ist, das erste und das zweite Anregungssignal derart zu erzeugen, dass sich Ladungen, welche an einer der ersten Sensoreinrichtung zuordenbaren parasitären Kapazität vorliegen, mit Ladungen, welche an einer der zweiten Sensoreinrichtung zuordenbaren parasitären Kapazität vorliegen, über einen Ausgleichspfad außerhalb des ersten und/oder des zweiten Anregungssignalpfads wenigstens teilweise kompensieren.

Jeder Sensoreinrichtung ist insbesondere eine jeweilige Ausleseeinrichtung zugeordnet.

Bei kapazitiven Sensoreinrichtungen verändert sich deren Sensorkapazität in Abhängigkeit von einem mechanischen Einfluss, beispielsweise einer Verlagerung, Auslenkung oder einer Verschiebung von Kondensatorelementen relativ zueinander. Durch die Erzeugung der ersten und zweiten Anregungssignale derart, dass parasitäre Ladungen über elektrische Verbindungen einander kompensieren, die nicht im Anregungssignalpfad liegen, können erhöhte Anregungsfrequenzen für eine Ausleseschaltung realisiert werden. Man kann sagen, dass die beiden Anregungssignale zu einander "balanciert" erzeugt und eingekoppelt werden. Beim Auslesen einer jeweiligen Sensoreinrichtung durch eine Auswerteeinrichtung entspricht eine erfasste Messspannung der jeweiligen Sensorkapazität.

Insofern erfasst beispielsweise die der ersten Sensoreinrichtung zugeordnete erste Ausleseeinrichtung eine aufgrund des eingekoppelten ersten Anregungssignals an der ersten Sensorkapazität akkumulierte Messladung, und die der zweiten Sensoreinrichtung zugeordnete zweite Ausleseeinrichtung erfasst eine aufgrund des eingekoppelten zweiten Anregungssignals an der zweiten Sensorkapazität akkumulierte Messladung.

Durch ein erstes Anregungssignal, beispielsweise eine steigende Spannung an Elementen einer Sensoreinrichtung, können sich aufgrund der parasitären Kapazität Ladungen aufbauen. Es wird nun vorgeschlagen, beispielsweise gemäß einem Verfahren zum Betreiben der Sensoranordnung, die Anregungssignale so zu erzeugen, dass sich akkumulierte Ladungen an verschiedenen Sensoreinrichtungen kompensieren. Dadurch, dass nicht über den Anregungssignalpfad, also über Anschlussleitungen an die jeweiligen Kondensatoren der Sensoreinrichtung, die akkumulierten parasitären Ladungen abfließen, sondern über einen getrennten Pfad, werden parasitäre Ladungen an parasitären Kondensatoren schnell abgeleitet, sodass am Ausgang der jeweiligen kapazitiven Sensoreinrichtung rasch der Spannungspegel erreicht wird, der eingangsseitig durch das jeweilige Ansteuersignal eingekoppelt ist. In der Folge liegt an der jeweiligen Sensorkapazität die akkumulierte Messladung vor, welche als Maß für eine Auslenkung, Lage oder Stellung des betrachteten optischen Elements verwendet wird. Eine Ausleseelektronik, beispielsweise eine Switched-Capacitor-Schaltung, erfasst diese Messladung und liefert ein Messspannungssignal zur weiteren Verarbeitung.

Als parasitäre Kapazität wird insbesondere eine Kapazität verstanden, die eine Ladungsanreicherung ermöglicht, welche dazu führt, dass eine andere als die gemäß eigentlichen Sensorkapazität akkumulierte Messladung ermittelt werden könnte. Man kann Kapazitäten, die nicht zwischen zwei Kondensatorelementen, zwischen denen die Sensorkapazität gemessen oder erfasst wird, vorliegend als parasitäre oder Streukapazitäten verstehen.

Das erste und das zweite Anregungssignal sind zum Beispiel bezüglich einem Offset-Potenzial invers zueinander. In Ausführungsformen, bei denen das Offset-Potenzial Masse ist oder verschwindet, sind das erste und das zweite Anregungssignal invers zueinander. Es kann beispielsweise eine gepulste Signalform für das Anregungssignal vorgesehen sein, wobei das erste Anregungssignal z.B. einen positiven Spannungspuls und das zweite einen negativen Spannungspuls hat. Dadurch laden sich in der Sensoranordnung parasitäre Kapazitäten entgegengesetzt zueinander auf. Das heißt, die akkumulierten (parasitären) Ladungen können über einen geeigneten elektrischen Signalpfad einander auslöschen.

In Ausführungsformen ist das erste und/oder das zweite Anregungssignal ein Wechselspannungssignal, insbesondere ein Rechtecksignal. Denkbar sind z.B. Puls- oder Wechselspannungsfrequenzen zwischen zwei und drei Megahertz. In Ausführungsformen werden Frequenzen von 0,5 bis 3,0 Megahertz, bevorzugt zwischen 2,4 und 2,6 Megahertz eingesetzt.

In einer weiteren Ausführungsform der Sensoranordnung ist das erste und/oder das zweite Anregungssignal ein Spannungssignal mit einem vorgegebenen Nominalspannungsverlauf über einen vorgegebenen Anregungszeitraum. Die Spannung wird beispielsweise gegenüber einem Referenzpotenzial eingestellt, das ebenfalls von der Steuereinrichtung der Sensoreinrichtung geliefert wird. Das jeweilige Spannungssignal mit Nominalspannungsverlauf, beispielsweise eine Rechteckpulsform, führt zum Aufladen der kapazitiven Sensoreinrichtung. Daraus wird wiederum über eine, beispielsweise differenzielle, Ausleseschaltung ein Ausgangspannungssignal erfasst oder ermittelt, welches der Lagebestimmung dient. Das Ausgangsspannungssignal wird insbesondere einem Analog-Digital-Wandler zur weiteren Verarbeitung zugeführt.

Die jeweilige Amplitude bzw. der Betrag des Spannungssignals für das erste und das zweite Anregungssignal können gleich sein. Dabei kann die Amplitude als Betrag der Differenz zwischen dem jeweiligen Potenzial des Spannungssignals und einem Referenzpotenzial verstanden werden. In Ausführungsformen wird eine Amplitude des Spannungssignals in einem ersten Anregungsabschnitt des Anregungszeitraums größer als die dem Nominalspannungsverlauf entsprechende Nominalamplitude eingestellt. Man kann sagen, dass in dem ersten Anregungsabschnitt eine Art Überschwingung erfolgt, so dass die Kapazitäten der kapazitiven Sensoreinrichtung besonders schnell aufgeladen werden. Dadurch kann eine noch höhere Anregungsfrequenz erzielt werden, da die Sensorkapazitäten beschleunigt ihren stationären Zustand einnehmen. Ein Nominalspannungsverlauf kann dabei einen Offset-Anteil aufweisen, der insbesondere dem jeweiligen Referenzpotenzial entspricht,
Insofern kann die Amplitude des Spannungssignals in einem zweiten Anregungsabschnitt der Nominalamplitude entsprechen. Der erste und der zweite Anregungsabschnitt bilden dann zusammen den Anregungszeitraum. Es ist ferner möglich, das zwischen aufeinanderfolgenden Anregungszeitraum über einen vorgegebenen Pausenzeitraum das erste und/oder das zweite Anregungssignal einem Referenzpotential entspricht. Es sind somit gepulste Anregungssignale mit verschiedenen zeitlichen Verläufen möglich. Innerhalb des Anregungszeitraums, der einer Periode entsprechen kann, kann durch die Festlegung des ersten und des zweiten Anregungsabschnitts ein Tastverhältnis festgelegt werden. Beispielsweise ist der erste Anregungsabschnitt kürzer als der zweite Anregungsabschnitt.

Vorzugsweise wird die Amplitude des ersten und des zweiten Anregungssignals in Abhängigkeit von erfassten parasitären Kapazitäten eingestellt. Bei einer symmetrischen Ausgestaltung der ersten und der zweiten Sensoreinrichtung kann man davon ausgehen, dass die parasitären Kapazitäten vom Betrag her etwa gleich sind. Durch die gegenphasige Ansteuerung bzw. Einkopplung von Anregungssignalen mit gleicher Amplitude aber unterschiedlicher Vorzeichen kann sich dann eine Kompensation von parasitären Ladungen ergeben.

In Ausführungsformen hat die Sensoranordnung ferner ein Basiselement und ein Strukturelement zum Halten eines optischen Elements und ein Lagerelement zum beweglichen Lagern des Strukturelements an dem Basiselement. Die Sensoranordnung kann beispielsweise Spiegel als optische Elemente mit wenigen Quadratmillimeter Fläche lagern und ein Kipp- oder Neigungswinkel bestimmen. Als optisches Element kommt insbesondere ein Spiegel in einer Facettenspiegelanordnung in Frage.

Das Strukturelement, das Lagerelement und das Basiselement können aus einem Halbleiter, insbesondere aus Siliziummaterial, gefertigt sein. Insofern kann die Sensoranordnung als Halbleiterbauelement hergestellt werden. Beispielsweise ist das Lagerelement eine federähnliche Struktur im Zentrum einer Fläche die sich mit Hilfe der federartigen Struktur um verschiedene Dreh- oder Kippwinkel neigen lässt. Das Strukturelement ist beispielsweise Teil eines MEMS.

In Ausführungsformen der Sensoranordnung hat die erste oder die zweite Sensoreinrichtung wenigstens ein erstes und ein zweites Kondensatorelement, welche relativ zueinander ortsfest sind und ein relativ zu dem ersten und zweiten Kondensatorelement bewegliches drittes Kondensatorelement. In Abhängigkeit von einer Stellung der Kondensatorelemente zueinander tritt dann die Sensorkapazität zwischen dem ersten und dem zweiten Kondensatorelement auf.

Die Sensorkapazität wird insbesondere mit Hilfe des über Zuleitungen an das erste und das zweite Kondensatorelement ankoppelbare Anregungssignals erfassbar. Z.B. können ortsfeste Kondensatorelemente beabstandet voneinander vorgesehen sein, so dass ein drittes Bewegliches in den Zwischenraum der beiden Kondensatorelemente greift und je nach Stellung in den Zwischenraum eine Sensorkapazität verändert. Außerdem kann zwischen dem ersten und dem dritten und zwischen dem zweiten und dem dritten Kondensatorelement eine parasitäre Kapazität auftreten, die im herkömmlichen Fall zu einer Beeinträchtigung des Betriebs führen können.

In Ausführungsformen sind das erste und das zweite Kondensatorelement an dem Basiselement angeordnet, und das dritte Kondensatorelement ist an dem Strukturelement angeordnet. Das Strukturelement kann beispielsweise in der Art einer Platte mit Hilfe der Lagereinrichtung gegenüber dem Basiselement geneigt oder gekippt werden. Dabei sind das Basiselement, das Strukturelement und die Lageeinrichtung vorzugsweise materialeinstückig ausgebildet. Ferner können, beispielsweise bei einer halbleiter- oder siliziumbasierten Sensoranordnung, elektrische Zu- und Ableitungen integriert sein. Die Lageeinrichtung kann insbesondere dotiertes Siliziummaterial aufweisen.

In Ausführungsformen sind die erste und die zweite Sensoreinrichtung differenziell ausgeführt, und die Sensoreinrichtungen sind zum Erfassen von zwei verschiedenen Kippbewegungen angeordnet. Beispielsweise kann eine erste differenzielle Sensoreinrichtung Sensorkapazitätspaare umfassen, die gegenüber eines Kipp- oder Neigungspunktes angeordnet sind. Vorzugsweise sind die beiden differenziellen Sensoreinrichtungen dazu eingerichtet, senkrecht aufeinander liegende Neigungen bzw. Kippachsen zu Erfassen.

In Ausführungsformen sind die ersten und die zweiten Kondensatorelemente einzeln mit Hilfe von Zuleitungen, welche in oder an dem Basiselement vorgesehen sind, kontaktierbar. Die dritten Kondensatorelemente sind insbesondere über das Strukturelement elektrisch miteinander gekoppelt. Da insbesondere parasitäre Ladungen an den dritten Kondensatorelementen auftreten, erfolgt ein Ladungsausgleich zumindest teilweise über das Strukturelement, insbesondere dann, wenn die jeweiligen Anregungssignale "balanciert" sind. Das heißt die durch die Anregungssignale hervorgerufenen Ladungen haben unterschiedliche Vorzeichen, so dass sie sich über einen Ausgleichspfad ausgleichen und die parasitären Kapazitäten nur noch geringfügig stören.

Gemäß einem weiteren Aspekt der vorliegenden Erfindung wird eine Lithographieanlage mit wenigstens einem optischen Element und einer Sensoreinrichtung wie es zuvor oder im Folgenden beschrieben wird, vorgeschlagen.

Die Sensoreinrichtung dient dabei dem Erfassen der Lage des optischen Elements. Die Lithographieanlage kann ferner eine Strahlungsquelle oder eine Beleuchtungseinrichtung umfassen. Insofern ist die Lithographieanlage mit einer Sensoranordnung ausgestattet, die mit Hilfe von kapazitiven Sensoren die Messung der Position oder eines Kippwinkels des optischen Elements ermöglicht. Vorzugsweise sind die Elektroden oder die Kondensatorelemente des kapazitiven Sensors kammförmig ausgebildet und verzahnt angeordnet.

Die Steuereinrichtung ist insbesondere als ASIC implementiert.

Außerdem wird ein Verfahren zum Betreiben einer Lithographieanlage vorgeschlagen. Es wird dabei wenigstens einer der folgenden Schritte durchgeführt:
Erzeugen des ersten und des zweiten Anregungssignals derart, dass sich Ladungen, welche an der ersten Sensoreinrichtung zuordenbaren Kapazität vorliegen, mit Ladungen, welche an der der zweiten Sensoreinrichtung zuordenbaren parasitären Kapazität vorliegen, über ein Signalpfad außerhalb des ersten und/oder des zweiten Anregungssignalpfads wenigstens teilweise kompensieren;
Erfassen der ersten und der zweiten Sensorkapazität; und/oder
Bestimmen einer Neigung oder Lage des optischen Elements in Abhängigkeit von der erfassten ersten und zweiten Sensorkapazität.

Bei dem optischen Element kann es sich insbesondere um einen Mikrospiegel, mit einer Seitenlänge von weniger als 1 mm handeln. Der Spiegel oder Mikrospiegel kann insbesondere Bestandteil einer Vielspiegel-Anordnung (Multi-Mirror Array, MMA) sein. Denkbar sind MMAs mit mehr als 500 Einzelspiegeln. Das MMA kann jedoch auch über 1.00, insbesondere über 1.000, besonders bevorzugt über 10.000 derartiger Spiegel umfassen. Es kann sich insbesondere um Spiegel zur Reflexion von EUV-Strahlung handeln.

Das optische Element kann daher auch Teil eines Facettenspiegels, insbesondere eines Feldfacettenspiegels, eines Strahlformungs- und Beleuchtungssystems der Lithographieanlage sein. Dabei ist das optische Element insbesondere in einer evakuierbaren Kammer angeordnet. Beim Betrieb der Lithographieanlage kann diese evakuierbare Kammer insbesondere auf einen Druck von weniger als 50 Pa, insbesondere weniger als 20 Pa, insbesondere weniger als 10 Pa, insbesondere weniger als 5 Pa evakuiert werden. Hierbei gibt dieser Druck insbesondere den Partialdruck von Wasserstoff in der evakuierbaren Kammer an.

Die in einer Lithographieanlage eingesetzte Strahlungsquelle ist insbesondere eine EUV-Strahlungsquelle mit einer emittierten Nutzstrahlung im Bereich zwischen 0,1 nm und 30 nm, bevorzugt zwischen 4 und 6 nm. Es kann sich dabei um eine Plasmaquelle, beispielsweise um eine GDPP-Quelle (Plasmaerzeugung durch Gasentladung, Gas Discharge Produced Plasma) oder um eine LPP-Quelle (Plasmaerzeugung durch Laser, Laser-Produced Plasma) handeln. Auch andere EUV-Strahlungsquellen, beispielsweise basierend auf einem Synchronton oder auf einem freien Elektronenlaser (Free Electron Laser, FEL), sind möglich. Gemäß einer Ausführungsform ist die Lithographieanlage eine EUV-Lithographieanlage.

Die Einzelspiegel sind in einer Weiterbildung jeweils mittels einer Aktuator-Einrichtung mit mehreren elektromagnetisch, insbesondere elektrostatisch arbeitenden Aktuatoren verlagerbar, insbesondere positionierbar. Die Aktuatoren lassen sich in einem Batch-Prozess als mikroelektromechanisches System (Micro-Electro-Mechanical System, MEMS) herstellen. Für Details wird hierzu auf das Dokument WO 2010/049 076 A1 verwiesen. Zur Ausbildung des Feldfacettenspiegels sowie zur Ausbildung des Pupillenfacettenspiegels wird auf die DE 10 2013 209 442 A1 verwiesen.

Die für die vorgeschlagene Vorrichtung beschriebenen Ausführungsformen und Merkmale gelten für das vorgeschlagene Verfahren entsprechend.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Die jeweilige Einheit, zum Beispiel eine Steuereinrichtung, Auswerte- oder Ausleseeinheit kann hardwaretechnisch und/oder auch softwaretechnisch implementiert sein. Es können auch nur Teile der Steuerungs- oder Auswerteelektronik softwaretechnisch implementiert sein. Bei einer hardwaretechnischen Implementierung kann die jeweilige Einheit als Vorrichtung oder als Teil einer Vorrichtung, zum Beispiel als Computer oder als Mikroprozessor oder als Steuerrechner einer Lithographieanlage ausgebildet sein. Bei einer softwaretechnischen Implementierung kann die jeweilige Einheit als Computerprogrammprodukt, als eine Funktion, als eine Routine, als Teil eines Programmcodes oder als ausführbares Objekt ausgebildet sein.

Es kann in Computerprogrammprodukt bereitgestellt werden, welches auf einer programmgesteuerten Einrichtung das Betreiben einer Lithographieanlage des wie oben erläuterten Verfahrens derart veranlasst, dass das erste und das zweite Anregungssignal balanciert zueinander eingekoppelt werden.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen. Die Erfindung wird durch die Ansprüche definiert.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt eine schematische Darstellung einer ersten Ausführungsform einer Sensoranordnung.
Fig. 2 zeigt eine beispielhafte Signalform für Anregungssignale in einer Sensoranordnung.
Fig. 3 zeigt eine schematische Ansicht einer EUV-Lithographieanlage.
Fig. 4 zeigt eine erste schematische Darstellung eines Teils einer zweiten Ausführungsform einer Sensoranordnung für eine Lithographieanlage.
Fig. 5 zeigt ein schematisches Ersatzschaltbild für den Teil der zweiten Ausführungsform einer Sensoranordnung gemäß Fig. 4.
Fig. 6 zeigt eine zweite schematische Darstellung eines Teils der zweiten Ausführungsform einer Sensoranordnung für eine Lithographieanlage.
Fig. 7 zeigt ein schematisches Ersatzschaltbild für die zweite Ausführungsform einer Sensoranordnung.
Fig. 8 zeigt ein vereinfachtes schematisches Ersatzschaltbild für die zweite Ausführungsform einer Sensoranordnung.
Fig. 9 und 10 zeigen Fehlerkurven für mit Hilfe der zweiten Ausführungsform einer Sensoranordnung erfasste Neigungen bei verschiedenen Anregungssignalfrequenzen mit und ohne "balancierter" Anregung.
Fig. 11 zeigt weitere beispielhafte Signalformen für Anregungssignale in einer Sensoranordnung.
Fig. 12 zeigt ein vereinfachtes schematisches Ersatzschaltbild eine dritte Ausführungsform einer Sensoranordnung.
Fig. 13 zeigt weitere beispielhafte Signalformen für Anregungssignale in einer Sensoranordnung.

In den Figuren sind gleiche oder funktionsgleiche Elemente mit denselben Bezugszeichen versehen worden, sofern nichts anderes angegeben ist. Ferner sollte beachtet werden, dass die Darstellungen in den Figuren nicht notwendigerweise maßstabsgerecht sind.

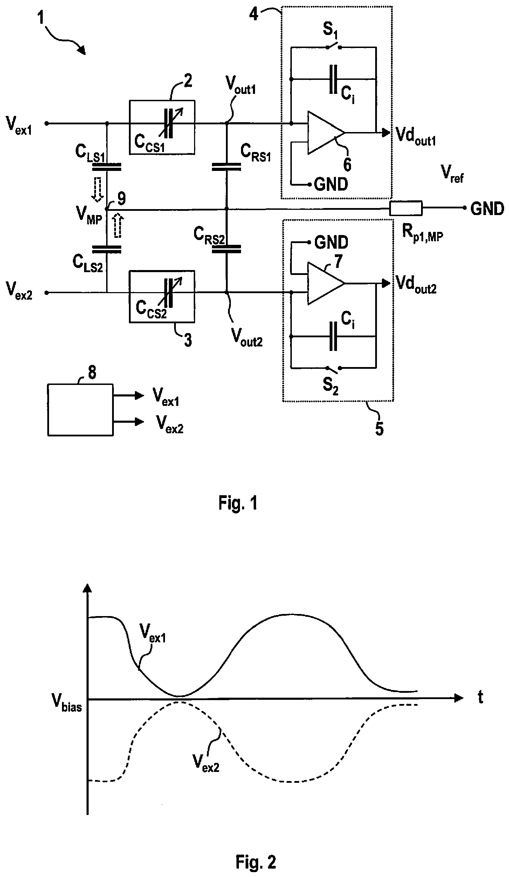

Die Fig. 1 zeigt eine schematische Darstellung einer ersten Ausführungsform einer Sensoranordnung in einer möglichen single-ended Ausgestaltung. Die Sensoranordnung 1 umfasst dabei zwei Sensoreinrichtungen 2,3. Eine jeweilige Sensoreinrichtung 2, 3 liefert eine veränderbare Sensorkapazität Ccsi bzw. C_{CS2}. Im Signalpfad von links nach rechts ist jeder Sensoreinrichtung 2, 3 eine Ausleseeinrichtung 4, 5 nachgeordnet. Ferner ist eine Steuereinrichtung 8 vorgesehen, die Anregungs- oder Auslesesignale Vₑₓ₁, Vₑₓ₂ erzeugt. Die Steuereinrichtung 8 kann weitere Funktionen vollziehen, beispielsweise Steuer- oder Schaltsignale liefern.

In der Regel liegen neben der jeweiligen Sensorkapazität C_{CS1}, C_{CS2} auch weitere parasitäre Kapazitäten vor. Parasitäre Kapazitäten sind zum Beispiel bezogen auf ein Potential V_{MP}, das z.B. an einer Halteplatte vorliegen kann, die selbst einen Widerstand Rₚ₁, _{MP} hat und an Masse GN angeschlossen ist, denkbar. Zwischen der jeweiligen Leitung, die auf dem Potential V_{MP} liegt, und einem Eingang und Ausgang der Sensoreinrichtung 2 liegen parasitäre Kapazitäten C_{LS1} und C_{RS1} vor. Analog können der zweiten Sensoreinrichtung 3 parasitäre Kapazitäten C_{LS2} und C_{RS2} zugeordnet werden.

Wird nun der ersten Sensoreinrichtung 2 ein Anregungssignal Vₑₓ₁ angekoppelt, akkumulieren sich zunächst in Abhängigkeit von dem Sensorkapazitätswert C_{CS1} Messladungen am Sensor, und es stellt sich eine Ausgangsspannung Vₒᵤₜ₁ ein. Bei Einkoppeln von Vₑₓ₂ an die zweite Sensorkapazität C_{CS2} bzw. an die zweite Sensoreinrichtung 3, ergibt sich ebenso eine Messladungsakkumulation und ein Ausgangssignal Vₒᵤₜ₂. Mit Hilfe einer jeweiligen Ausleseschaltung 4, 5 die beispielsweise auf einer SC- (switched capacitor) Technik basiert, wird durch Integration der Messladungen ein Ausgangssignal Vdₒᵤₜ₁ bzw. Vdₒᵤₜ₂ erzeugt. Das Ausgangssignal Vdₒᵤₜ₁ bzw. Vdₒᵤₜ₂ kann als Maß für eine Auslenkung oder Lageveränderung betrachtet werden, die zu der bestimmten Sensorkapazität Ccsi bzw. C_{CS2} bzw. zu den aufgrund des eingekoppelten Anregungssignals Vₑₓ₁, Vₑₓ₂ akkumulierten Messladungen führt.

Die in der Fig. 1 dargestellt Sensoranordnung ermöglicht unabhängig voneinander mit jeder der Sensoreinrichtungen 2,3 eine Lageänderung zu erfassen. Die Ausleseschaltungen 4, 5 integrieren mit Hilfe eines Operationsverstärkers 6,7 das Eingangssignal. An dem Operationsverstärker 6,7 sind eingangsseitig das Referenzpotenzial bzw. Masse GND sowie jeweils die am jeweiligen Ausgang der Sensoreinrichtung 2,3 abgreifbare Spannung Vₒᵤₜ₁ und Vₒᵤₜ₂ zugeführt. Über ein Integrationskondensator Ci und einen steuerbaren Schalter S₁ bzw. S₂ wird die Signalintegration vollzogen. Am Ausgang des Operationsverstärkers 6 liegt dann das Signal Vdₒᵤₜ₁ und am Ausgang des Operationsverstärkers 7 das Signal Vdₒᵤₜ₂. Bei geöffneten Schaltern S₁, S₂ werden Spannungspulse als Anregungssignale Vₑₓ₁, Vₑₓ₂ eingekoppelt. Dies erfolgt durch die Steuereinrichtung 8. Die dadurch akkumulierte Ladung am Integrationskondensator Ci wird durch die Integration in eine Spannung umgewandelt, die als Ausgangssignal Vdₒᵤₜ₁, Vdₒᵤₜ₂ abgreifbar ist.

Störend wirken sich beim Betrieb der Sensoranordnung die parasitären Kapazitäten C_{LS1}, C_{RS1}, C_{LS2}, C_{RS2} aus. Denn durch die zusätzlichen Kapazitäten wird einerseits die mit Hilfe der Auswerteschaltung integrierte Ladung verfälscht, und andererseits dauert es länger, bis die Spannungspegel der Anregungssignale Vₑₓ₁, und Vₑₓ₂ als Vₒᵤₜ₁ und Vₒᵤₜ₂ an den Eingängen der Operationsverstärker 6, 7 vorliegen. Es werden nun mit Hilfe der Steuereinrichtung 8 die Anregungssignale Vₑₓ₁ und Vₑₓ₂ aufeinander abgestimmt oder "balanciert" erzeugt. Dies erfolgt derart, dass Ladungsträger, die sich an den parasitären Kapazitäten C_{LS1}, C_{RS1} bilden, mit Ladungsträgern, die sich an den Kapazitäten C_{LS2} und C_{RS2} akkumulieren, im Wesentlichen ausgleichen. Wie in der Fig. 1 mit Hilfe der gestrichelten Blockpfeile angedeutet ist, können sich die Ladungen ausgleichen, so dass die parasitären Kapazitäten C_{LS1}, C_{LS2}, für die Sensorauslesung bzw. die Bestimmung der Sensorkapazitäten C_{CS1}, C_{CS2} kaum noch einen störenden Einfluss haben. Darüber hinaus vorliegende parasitäre Ladungen können über den Widerstand R_{p1,MP} abfließen.

Beispielsweise kann das erste und das zweite Anregungssignal Vₑₓ₁ und Vₑₓ₂ invers zueinander erzeugt werden.

In der Fig. 2 ist eine beispielhafte Darstellung für eine Signalform für Anregungssignale angegeben. Während das erste Anregungssignal Vₑₓ₁ bezüglich einem potenziellen Offset-potential V_{bias} eine positive "Amplitude" hat, hat das zweite Anregungssignal Vₑₓ₂ eine negative "Amplitude". Dadurch können sich, beispielsweise wie in der Fig. 1 angedeutet ist, am Leitungsknoten 9 die am Kondensator C_{LS1} akkumulierten Ladungen mit den am Kondensator C_{LS2} akkumulierten Ladungen aufheben. Insgesamt erfolgt dabei ein Ladungsausgleich der parasitären Ladungen nicht über den Auslesesignalpfad, also zwischen dem Einkopplungsanschluss Vₑₓ₁ bis zum Eingang am Operationsverstärker 6, sondern außerhalb dessen. Dadurch, dass die Sensoranordnung 1 zwei Sensoreinrichtungen 2, 3 umfasst, die balanciert angesteuert werden, wird sowohl der kritische Zuleitungswiderstand wie auch die Kondensatoreinflüsse durch parasitäre Kapazitäten minimiert. In der Folge sind höhere Anregungsfrequenzen bei einem günstigeren Signalrauschverhältnis möglich.

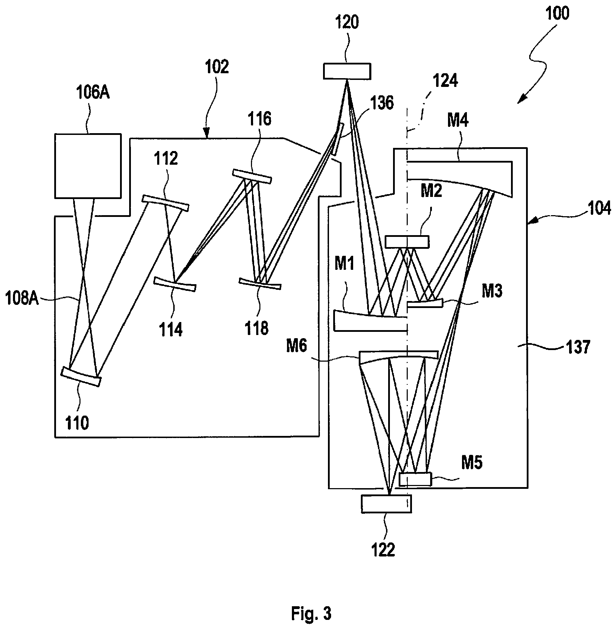

Die als "single-ended" Sensoranordnung 1 angegebene Ausführungsform in Fig. 1 kann beispielsweise zum Erfassen von Kippwinkeln oder Neigungen in verschiedenen Neigungsachsen für Spiegel eingesetzt werden. Z. B. kann die Sensoranordnung 1 in einer wie in Fig. 3 gezeigten Lithographieanlage eingesetzt werden.

Fig. 3 zeigt eine schematische Ansicht einer EUV-Lithographieanlage 100, welche ein Strahlformungs- und Beleuchtungssystem 102 und ein Projektionssystem 104 umfasst. Dabei steht EUV für "extremes Ultraviolett" (Engl.: extreme ultraviolett, EUV) und bezeichnet eine Wellenlänge des Arbeitslichts zwischen 0,1 und 30 nm. Das Strahlformungs- und Beleuchtungssystem 102 und das Projektionssystem 104 sind jeweils in einem Vakuum-Gehäuse vorgesehen, wobei jedes Vakuum-Gehäuse mit Hilfe einer nicht näher dargestellten Evakuierungsvorrichtung evakuiert wird. Die Vakuum-Gehäuse sind von einem nicht näher dargestellten Maschinenraum umgeben. In diesem Maschinenraum können auch elektrische Steuerungen und dergleichen vorgesehen sein.

Die EUV-Lithographieanlage 100 weist eine EUV-Strahlungsquelle oder EUV-Lichtquelle 106A auf. Als EUV-Lichtquelle 106A kann beispielsweise eine Plasmaquelle vorgesehen sein, welche Strahlung 108A im EUV-Bereich (extrem ultravioletten Bereich), also z.B. im Wellenlängenbereich von 5 nm bis 30 nm aussenden. Im Strahlformungs- und Beleuchtungssystem 102 wird die EUV-Strahlung 108A gebündelt und die gewünschte Betriebswellenlänge aus der EUV-Strahlung 108A herausgefiltert. Die von der EUV-Lichtquelle 106A erzeugte EUV-Strahlung 108A weist eine relativ niedrige Transmissivität durch Luft auf, weshalb die Strahlführungsräume im Strahlformungs- und Beleuchtungssystem 102 und im Projektionssystem 104 evakuiert sind.

Das in Fig. 3 dargestellte Strahlformungs- und Beleuchtungssystem 102 weist fünf Spiegel 110, 112, 114, 116, 118 auf. Nach dem Durchgang durch das Strahlformungs- und Beleuchtungssystem 102 wird die EUV-Strahlung 108A auf die Photomaske (Engl.: reticle) 120 geleitet. Die Photomaske 120 ist ebenfalls als reflektives optisches Element ausgebildet und kann außerhalb der Systeme 102, 104 angeordnet sein. Weiter kann die EUV-Strahlung 108A mittels eines Spiegels 136 auf die Photomaske 120 gelenkt werden. Die Photomaske 120 weist eine Struktur auf, welche mittels des Projektionssystems 104 verkleinert auf einen Wafer 122 oder dergleichen abgebildet wird.

Das Projektionssystem 104 weist sechs Spiegel M1 - M6 zur Abbildung der Photomaske 120 auf den Wafer 122 auf. Dabei können einzelne Spiegel M1 - M6 des Projektionssystems 104 symmetrisch zur optischen Achse 124 des Projektions-systems 104 angeordnet sein. Es sollte beachtet werden, dass die Anzahl der Spiegel der EUV-Lithographieanlage 100 nicht auf die dargestellte Anzahl beschränkt ist. Es können auch mehr oder weniger Spiegel vorgesehen sein. Des Weiteren sind die Spiegel M1- M6 i.d.R. an ihrer Vorderseite zur Strahlformung gekrümmt.

Insbesondere für die im Beleuchtungssystem 102 vorgesehenen Spiegel 110, 112, 114, 116, 118 können Facettenspiegel eingesetzt werden. Bei Facettenspiegeln werden größere Flächen durch kleine Spiegelelemente abgedeckt, wobei jedes Spiegelelement mit Hilfe von Aktoren lagegesteuert wird. Um die Aktoren, welche im Folgenden nicht näher erläutert werden, gezielt und sinnvoll anzusteuern, ist es notwendig, die Lage, und insbesondere die Kippwinkel, der Spiegelelemente in einem Facettenfeld zuverlässig zu erfassen. Da hohe Auslese- und Anregungsfrequenzen gewünscht sind, bietet sich das vorgeschlagene Verfahren und die Sensoranordnung zur Kompensation von Streukapazitäts- oder parasitären Widerstandseinflüssen dazu besonders an.

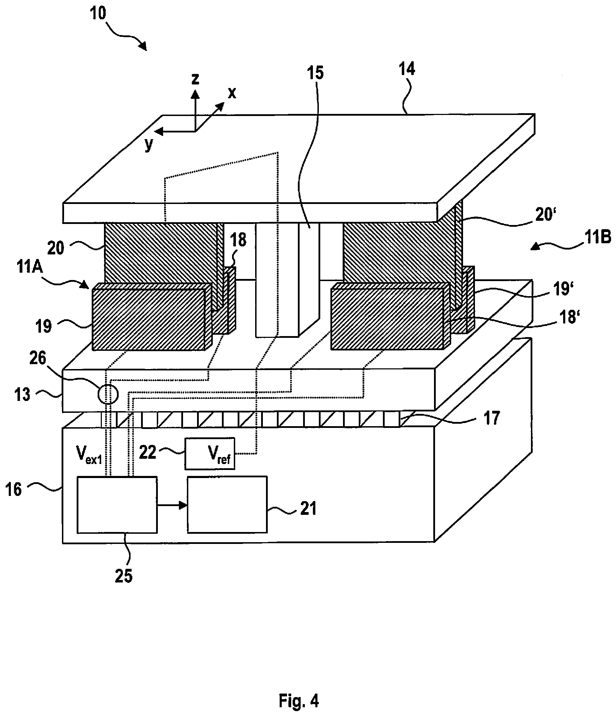

Anhand der Fig. 4 - 8 ist eine zweite Ausführungsform für eine Sensoranordnung und deren Ansteuerung bzw. ein Verfahren zum Betreiben der Sensoranordnung beschrieben. Dabei sind anhand der einzelnen Figuren zum Teil verschiedene Aspekte der Ausführungsform erläutert.

In der Fig. 4 ist nun eine erste schematische Darstellung eines Teils einer Ausführungsform einer Sensoranordnung für eine Lithographieanlage gezeigt. Die Fig. 4 zeigt im Wesentlichen ein MEMS-Element (micro electric mechanical system) 10. Die Sensoranordnung oder das MEMS 10 umfasst dabei ein Basiselement 13 und ein Strukturelement 14. Die beiden Elemente 13, 14 sind über eine Lagereinrichtung 15 miteinander gekoppelt, sodass das Strukturelement 14 beweglich ist.

Das Strukturelement 14 wird beispielsweise verwendet um einen Spiegel daran zu befestigen. Man spricht auch von einer Spiegelplatte (MP). Beispielsweise kann das Strukturelement 14 bzw. die Spiegelplatte 14 um die x-Achse geneigt werden. Um diesen Neigungswinkel zu erfassen, ist eine differenzielle kapazitive Sensoreinrichtung 11A, 11B vorgesehen. Die Sensoreinrichtung 11A, 11B ist zwischen den beiden plattenförmigen Basis- und Strukturelementen 13, 14 vorgesehen. Ein erster Teil der differenziellen kapazitiven Sensoreinrichtung 11A umfasst zwei Kondensatorelemente 18, 19, die an oder auf dem Basiselement 13 angebracht sind und von diesem abstehen. Eine gleichartig aufgebaute Sensoreinrichtung zum Erfassen der Neigung um die y-Achse ist in der Fig. 4 unterdrückt.

Die Kondensatorelemente 18, 19 sind plattenförmig und bilden einen Zwischenraum, in dem ein drittes Kondensatorelement 20, in der Orientierung der Fig. 4 von oben, eingreift. Das dritte Kondensatorelement 20 ist an der beweglichen Spiegelplatte 14 angebracht. Bezüglich der Lagereinrichtung 15, die als Stab- oder Federelement ausgebildet sein kann, ist der zweite Teil der Sensoreinrichtung 11B symmetrisch aufgebaut. Es sind wiederum zwei an dem Basiselement 13 befestigte Kondensatorelemente 18', 19' vorgesehen, und von oben ist in dem Zwischenraum ein drittes Kondensatorelement 20' anordenbar.

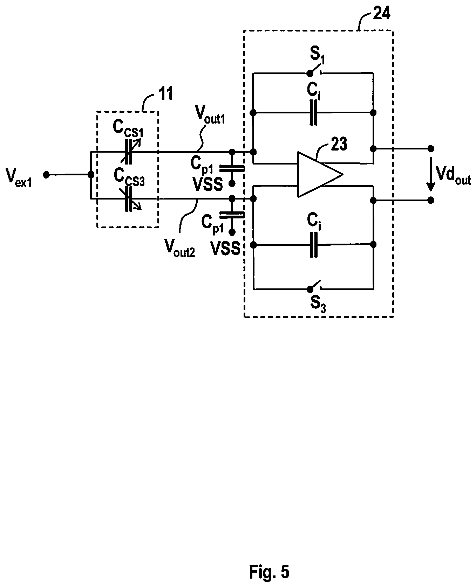

Die jeweiligen ersten und zweiten Kondensatorelemente 18, 19, 18', 19' bilden im Wesentlichen einen Plattenkondensator aus, dessen Kapazität sich durch die Stellung des dritten Kondensatorelements 20,20' verändert. Folglich akkumulieren sich beim Anlegen eines Anregungssignals als Spannungspuls je nach Stellung der Kondensatorelemente 18, 19, 18', 19' zueinander unterschiedliche Messladungen, die erfasst werden können. In der Fig. 5 ist ein schematisches Ersatzschaltbild für eine Auswahl des in der Fig. 4 gezeigten Teils der differenziellen kapazitiven Sensoreinrichtung 11A, 11B als 11 dargestellt.

An das Basiselement 13 ist unterseitig über Kontakte 17, wie beispielsweise ein Kontakt-Feld, eine Auswerteelektronik 16 angekoppelt. Die Auswerteelektronik 16 umfasst insbesondere eine Steuereinrichtung 25, die Anregungs- und Auslesesignale erzeugt, welche über Leitungen 26 an die Elektroden bzw. Kondensatorelemente 18, 19, 18', 19' geführt sind. Eine Referenzpotenzialeinrichtung 22 liefert ein Referenzpotenzial, das ebenfalls über in der Fig. 4 gepunktet dargestellte Leitungen, beispielsweise an die Spielplatte 14 geführt ist.

Die Steuereinrichtung 25 liefert nun ein Anregungssignal Vₑₓ₁ an die beiden Sensorkapazitäten C_{CS1}, C_{CS3}. In der Fig. 5 ist dies schematisch dargestellt. Die Fig. 5 zeigt ferner einige parasitäre Kapazitäten Cₚ₁ die an die Leitungen 26 koppeln. In der differenziellen Ausgestaltung der Sensoreinrichtung 11 erfolgt das Auslesen mit Hilfe einer differenziellen Ausleseelektronik 24. Dazu ist ein differenzieller Operationsverstärker 23 vorgesehen, dem eingangsseitig die Ausgänge der Sensorkapazitäten C_{CS1} und C_{CS2} angekoppelt sind. An dem jeweiligen Leitungsknoten liegt die stationäre Spannung Vₒᵤₜ₁, Vₒᵤₜ₂ an, die nach dem Laden der Kapazitäten C_{CS1} und C_{CS2} dem Wert von Vₑₓ₁ entspricht, welches der Sensoreinrichtung 11 als Anregungssignal zugeführt sind. Ausgangsseitig ist dann ein Ausgangssignal V_{dout}, welches eine Maß für die Neigung um die x-Achse ist, abgreifbar. Wie schon hinsichtlich der Fig. 1 erläutert wurde, steuert die Steuereinrichtung 25 über geeignete Steuersignale die Schalter S₁ und S₃ so, dass über die Integrationskondensoren Ci die am Sensor vorliegende Messladung integriert wird und der ausgangsseitig vorliegende Wert für die Ausgangsspannung V_{dout} als Maß für die Kapazitätsdifferenz zwischen C_{CS1} bzw. C_{CS3} und damit die unterschiedlichen Messladungen verwendet werden kann.

Obwohl es in der Fig. 4 nicht explizit angedeutet ist, ergeben sich parasitäre Kapazitäten zwischen den Platten 18 und 20, 19 und 20 bzw. 18' und 20', 19' und 20'. Das von der Steuereinrichtung 25 mit Hilfe der differenziellen Auswerteschaltung 24 erfasste Ausgangssignal V_{dout} wird als analoges Signal einem Analog- Digitalwandler zugeführt, der mit 21 bezeichnet ist. Die digitalisierten Werte können dann einem weiteren Leitrechner oder einer Regelungseinrichtung für die optischen Elemente in der Lithographieanlage zugeführt werden. Die Sensoranordnung kann insbesondere Teil einer aktiven Positionsregelung für Spiegelelemente in einem Beleuchtungssystem sein.

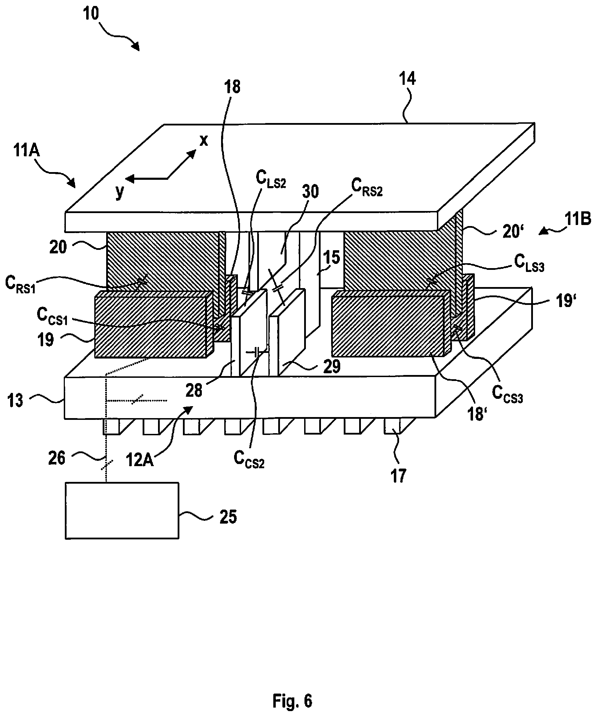

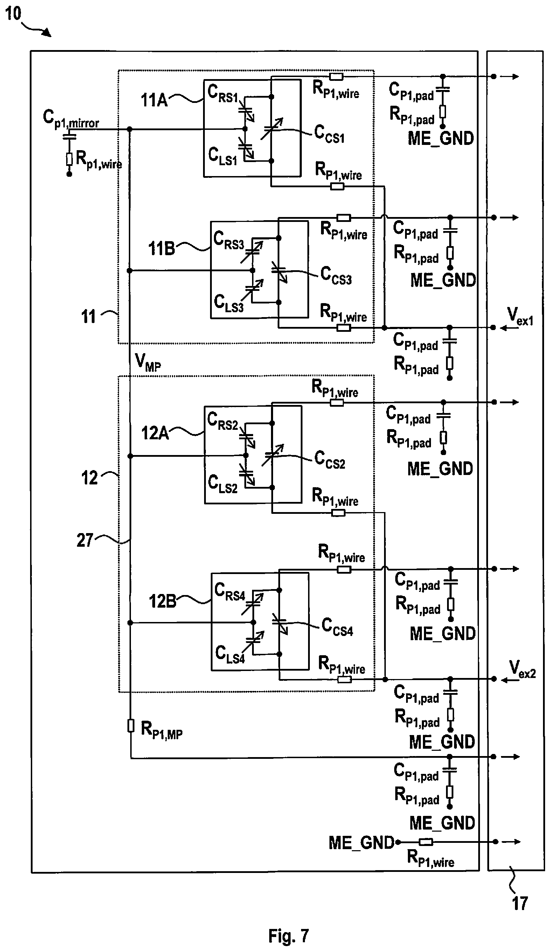

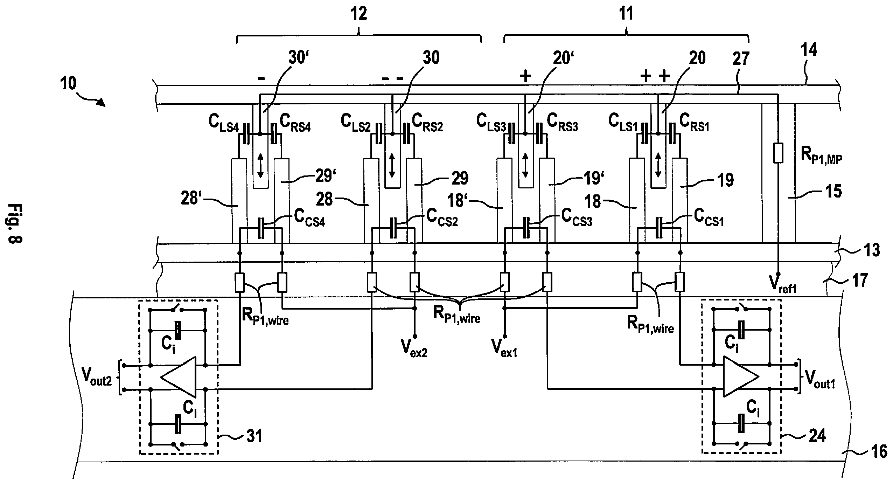

In der Fig. 6 ist eine erweiterte schematische Darstellung eines Teils der zweiten Ausführungsform der Sensoreinrichtung 10 für eine Lithographieanlage gezeigt. Dabei ist der Übersicht halber die vollständige Auswerteelektronik weggelassen. Ergänzend zu dem was in der Fig. 4 bereits dargestellt ist, ist eine Teil einer zweiten Sensoreinrichtung 12 wiedergegeben. Die Fig. 7 und 8 zeigen entsprechende Ersatzschaltbilder der gesamten Anordnung. Während die erste differenzielle Sensoreinrichtung 11A, 11B eine Kippbewegung um die x-Achse detektieren kann, ist die zweite differenzielle Sensoreinrichtung 12, 12A, 12B so vorgesehen, dass eine Kippbewegung um die y-Achse kapazitiv erfasst werden kann.

In der Darstellung der Fig. 6 sieht man nur den vorderen Teil mit zwei ortsfesten Kondensatorelementen 28,29 und einem von oben zwischen die beiden Kondensatorelemente 28,29 einführbaren dritten Kondensatorelement 30. Die Funktion ist analog bezüglich der zu Fig. 4 und 5 beschriebenen Erfassung des Kippwinkels um die x-Achse. In der Fig. 6 sind die Zuleitungen 26 nur mehr schematisch durch eine gepunktete Linie angedeutet. Die an der Basisplatte13 angeordneten Kondensatorelemente 18, 19,20, 18', 19', 20', 28, 29, 30 und 28', 29', 30' (nicht in der Figur dargestellt) sind alle einzeln über eine entsprechende Leitung kontaktierbar. Ein vereinfachtes Ersatzschaltbild für die zweite Ausführungsform einer Sensoranordnung ist in der Fig. 7 dargestellt. In der Fig. 8 ist ferner eine vereinfachte Darstellung des Ersatzschaltbildes aus Fig. 7 angedeutet.

Bezüglich der Fig. 7 bilden die jeweiligen Teile 11A und 11B die erste Sensorkapazität C_{CS1} und die differenzielle Sensoreinrichtung 11 aus, und die beiden Teile 12A und 12B die zweite kapazitive Sensoreinrichtung 12. In der Schaltungsanordnung gemäß der Fig. 7 sind zur Erläuterung einige parasitäre Widerstände mit R_{P1,pad} und Kapazitäten mit C_{P1,pad} bezeichnet. Darüber hinaus können noch weitere der Einfachheit halber nicht explizit genannte parasitäre Elemente vorliegen. Der Widerstand R_{p1,MP} entspricht dem Wesentlichen den Widerstand der Lagereinrichtung 30, die vorzugsweise aus einem dotierten Halbleitermaterial gefertigt ist. In der Fig. 6 sind für den Teil 12A der zweiten Sensoreinrichtung 12 die Sensorkapazität C_{CS2} und die parasitären Kapazitäten CLS₂ und C_{RS2} angedeutet.

In der vereinfachten Darstellung der Fig. 8 erkennt man von oben nach unten die Spiegelplatte 14, an der die beweglichen Kondensatorelemente 20, 20', 30 und 30' angeordnet sind. Die Kondensatorelemente 20, 20', 30, 30' bestehen zum Beispiel aus dotiertem Siliziummaterial. Die Bewegungsmöglichkeiten sind durch die Doppelpfeile angezeigt. An der Basisplatte 13 sind die jeweiligen Paare 18, 19; 18', 19'; 28, 29; 28', 29' von Kondensatorelementen angebracht. Die Verdrahtung ist mit 17 bezeichnet. Und in der Orientierung der Fig. 8 unterhalb ist eine integrierte Auswertelektronik vorgesehen. Es sind lediglich beispielhaft die beiden differenziellen Ausleseeinrichtungen 24, 31 angedeutet, die wie zu der Fig. 5 beschrieben wurde, betrieben wurden.

Man erkennt die erste Sensoreinrichtung 11 und die zweite Sensoreinrichtung 12 sowie die parasitären Kapazitäten C_{LS1}, C_{RS1}, C_{LS3}, C_{RS3}, C_{LS2}, C_{RS2}, C_{RS4} und C_{LS4}. Die erste Sensoreinrichtung 11 wird mit einem ersten Anregungssignal Vₑₓ₁ betrieben und die zweite Sensoreinrichtung 12 mit dem zweiten Anregungssignal Vₑₓ₂. Die beiden Anregungssignale Vₑₓ₁ und Vₑₓ₂ werden insbesondere antisymmetrisch bezüglich eines Offset-Potenzials erzeugt. Das Offset-Potenzial kann beispielsweise dem Potenzial V_{MP} der Spiegelplatte 14 entsprechen. Das heißt, die beiden Anregungssignale Vₑₓ₁ und Vₑₓ₂ sind von der Amplitude her gleich haben aber unterschiedliches Vorzeichen bezogen auf V_{MP} und verlaufen zeitsynchron. Man kann sagen, die Anregungssignale sind zueinander amplitudenbalanciert und miteinander zeitsynchronisiert. Beispielsweise ergibt sich dadurch, wie es in der Fig. 8 angedeutet ist, eine Ladungsakkumulation aufgrund der parasitären Kapazitäten C_{LS1} und C_{RS1}. Aufgrund der Bauform oder sonstiger Eigenschaften ergibt sich an dem Kondensatorelement 20' aufgrund der parasitären Kapazitäten C_{LS3}, C_{RS3} eine mittlere Ladungsakkumulation, die mit + bezeichnet ist. Da nun das zweite Anregungssignal Vₑₓ₂ die entgegengesetzte Spannung hat, beispielsweise Vₑₓ₂=-Vₑₓ₁, ergeben sich negative Ladungen, die sich aufgrund der parasitären Kapazitäten C_{LS4}, C_{RS4} und CLS₂ und C_{RS2} bilden. In der Fig. 8 ist dies durch ein doppeltes Minus -- und ein einfaches Minus - angedeutet. Diese Ladung kann sich nun über den Ausgleichspfad 27, der im Wesentlichen durch die Spiegelplatte MP gebildet ist, kompensieren. Das heißt die Ladungen -- und -gleichen sich mit den Ladungen + und ++ aus und führen nicht zu einer Verfälschung der Ladungsmessung im Sensorsignalpfad, der in der Fig. 8 jeweils durch die Widerstände R_{P1,wire} und die Sensorkapazitäten C_{CS1}, C_{CS3}, C_{CS2} und C_{CS4} verläuft.

Bei herkömmlichen Ansteuerungen ohne eine balancierte Bestimmung der beiden Ansteuersignale müssten die akkumulierten parasitären Ladungen über den relativ hohen Widerstand R_{P1,MP} abfließen. Dies ist mit einer angepassten Einkopplung der Anregungssignale Vₑₓ₁ und Vₑₓ₂ nicht mehr nötig. Ein Ableiten der an den parasitären Kapazitäten C_{LS4}, C_{RS4}, C_{LS2}, C_{RS2} vorliegenden Ladungen über R_{P1,MP} kann zumindest reduziert werden. In der Regel ist der Widerstand R_{P1, MP} einige Kiloohm groß, während die Verdrahtungswiderstände R_{P1,wire} lediglich einige hundert Ohm betragen.

Untersuchungen der Anmelderin haben nun ergeben, dass aufgrund der balancierten Ansteuerung, das heißt, das erste und das zweite Anregungssignal sind derart erzeugt, dass sich Ladungen, welche an einer der ersten Sensoreinrichtungen zuordenbaren parasitären Kapazität vorliegen, mit Ladungen, welche an einer der zweiten Sensoreinrichtung zuordenbaren parasitären Kapazität vorliegen, über einen Ausgleichsignalpfad (außerhalb des ersten oder des zweiten Anregungssignalpfads) wenigstens teilweise kompensieren, eine erhöhte Ansteuerungsfrequenz möglich ist. Das bedeutet, es können mehr Ausleseimpulse pro Zeit eingekoppelt werden als konventionell.

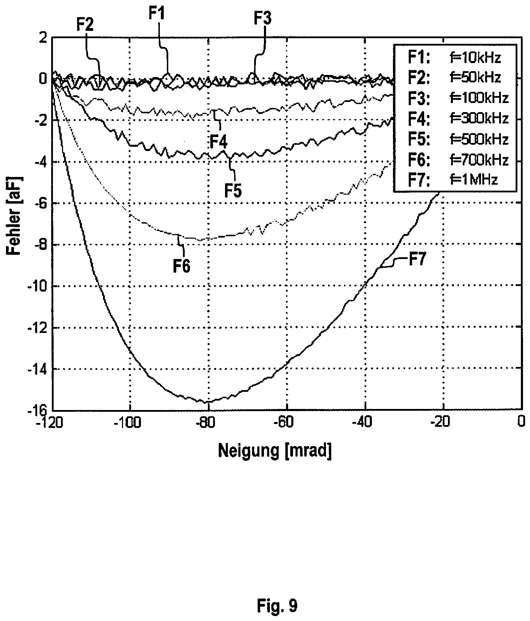

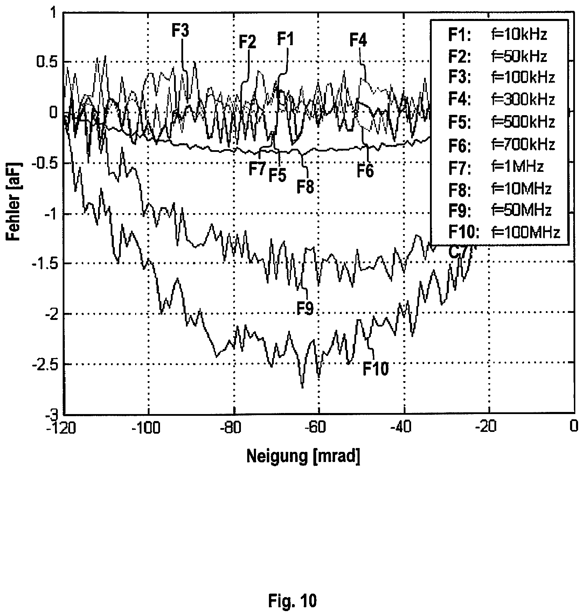

In Fig. 9 und 10 sind Fehlerkurven dargestellt, die einen Linearitätsfehler über einen Neigungswinkel zeigen. Bei einer idealen Kennlinie ist die jeweilige Sensorkapazität direkt proportional zu einer Auslenkung, die in dem vorliegenden Fall einem Kippwinkel entspricht. Aufgrund der parasitären Kapazitäten und Widerstände ergeben sich Abweichungen von dieser Linearität, die als Fehler in der Maßeinheit der Kapazität [aF] angezeigt sind. In der Fig. 9 sind nun 7 Fehlerkurven F1 bis F7 für unterschiedliche Anregungsfrequenzen zwischen 10 Kilohertz und einem Megahertz angedeutet. Zum Beispiel sind die jeweils betrachteten Anregungssignale Rechtecksignale mit einem Tastverhältnis von 1:1. Man erkennt, dass bei den Kurven F1 bis F4 der absolute Fehler bei weniger als zwei aF liegt. Bei höheren Frequenzen steigt der Fehler jedoch stark an. Übliche Sensorkapazitäten betragen zwischen 40 und 80 fF. Die Fig. 9 zeigt den Fehler bei einer nicht balancierten Ansteuerung der Sensoreinrichtungen aus Fig. 7. Das heißt, die beiden Sensoreinrichtungen 11A, 11B und 12A, 12B sind mit demselben Anregungssignal betrieben worden Vₑₓ₁=Vₑₓ₂.

In der Fig. 10 ist nun der Fehler für eine balancierte Ansteuerung, das heißt Vₑₓ₁=-Vₑₓ₂, wobei kein Offset angenommen wurde, für das in der Fig. 7 dargestellte Ersatzschaltbild berechnet worden. Es sind zehn Kurven F1 bis F10 für Anregungsfrequenzen zwischen 10 Kilohertz und 100 Megahertz angedeutet. Man erkennt, dass durch die balancierte Ansteuerung eine deutliche Reduktion des absoluten Fehlers in aF erfolgt. Im Vergleich zu Fig. 9 wurde der Fehler bei einem Megahertz (1MHz) Anregungsfrequenz auf weniger als 0,5 aF gebracht. Auch bei hohen Frequenzen, beispielsweise bei f=1 Megahertz (F7) liegt der Fehler noch unter 0,5 aF. Man erkennt dadurch, dass die vorgeschlagene Kompensation von parasitären Kapazitäten und Widerständen durch eine antisymmetrische Ansteuerung bzw. Ankopplung der Anregungssignale eine deutlich verbesserte Zeitkonstante für die Messungen ermöglicht. Das heißt es sind im Vergleich zum konventionellen Fall höhere Auslesefrequenzen möglich und somit kann auch ein höheres SNR erzielt werden.

Untersuchungen der Anmelderin haben darüber hinaus ergeben, dass sich eine weitere Verbesserung erzielen lässt, wenn die Anregungssignale kurzzeitig überschwingen. Es ist wünschenswert, die in der Sensoranordnung vorliegenden Kapazitäten möglichst rasch zu laden, und diese mit Hilfe einer Auswerteschaltung zu bestimmen. Das heißt, die ausgangsseitig der Sensorkapazität vorliegenden Spannung soll schnell auf einen stationären Wert gebracht werden, der der Spannung des Anregungssignals entspricht. Dazu wird in der Regel ein Spannungssignal mit einem vorgegebenen Nominalspannungsverlauf als Anregungssignal über einen vorgegebenen Anregungszeitraum eingekoppelt. Es ist dabei gewünscht, dass der beispielsweise in der Fig. 1 mit Vₒᵤₜ₁ und Vₒᵤₜ₂ am Ausgangsleitungsknoten der Sensorkapazitäten vorliegende Wert möglichst schnell einen stationären Wert einnimmt, der dem Nominalspannungswert entspricht. Um dies zu erzielen, kann vorübergehend - beispielsweise zu Beginn eines Anregungszeitraums - das Anregungssignal einen höheren Spannungswert haben als der Nominalspannungsverlauf vorsieht. In der Folge erfolgt ein schnelleres Aufladen der Kapazitäten.

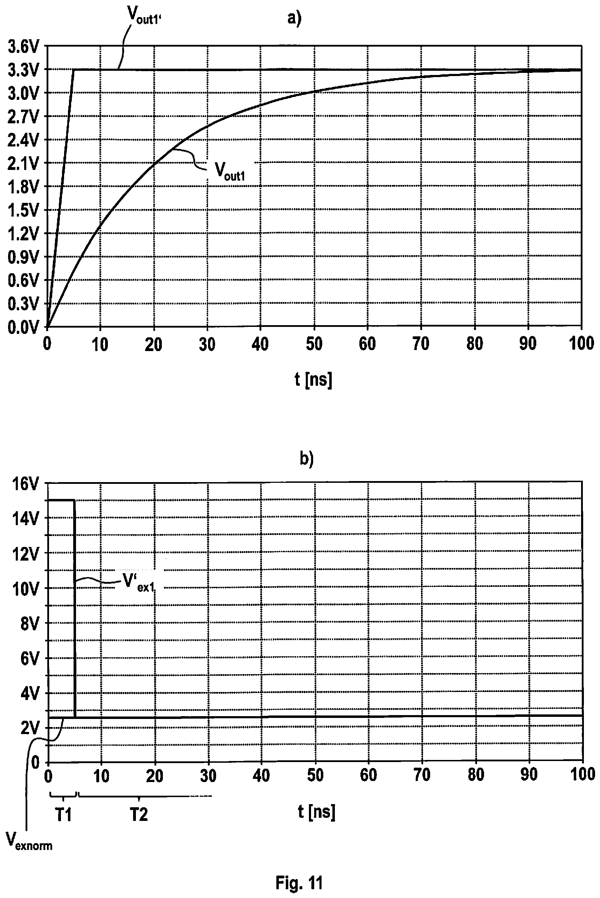

In der Fig. 11 sind zwei beispielhafte Formen für Anregungssignale dargestellt. In dem unteren Diagramm b) in der Fig. 11 ist ein Nominalspannungsverlauf Vₑₓₙₒᵣₘ angegeben, der über einen Anregungszeitraum T1+T2 konstant etwa 3,3 Volt beträgt. Beispielsweise ist die Anregungsfrequenz dann f=1/T, mit T=100ns 10 MHz. Dies führt zu einem Spannungsverlauf Vₒᵤₜ₁ (vgl. Fig. 1) wie er in dem oberen Diagramm a) der Fig. 11 angedeutet ist. Erst nach etwa 50 Nanosekunden schmiegt sich die Spannung an einen stationären Wert von Vₑₓₙₒᵣₘ =3,3 Volt an. Das heißt, der jeweilige Kondensator Ccsi ist erst dann vollständig geladen. Um die Ladezeit zu verringern, kann beispielsweise die in der unteren Fig. 11 b) dargestellte Signalform V'ₑₓ₁ eingekoppelt werden. Dazu wird über einen ersten Zeitabschnitt T1 ein erheblich höherer Pegel, nämlich 15 Volt, angelegt, was zu einem schnellen Laden der Kapazität C_{CS1} führt. Anschließend wird im Abschnitt T2 der Signalpegel V'ₑₓ₁ auf dem nominalen Wert von 3,3 Volt gehalten. In der oberen Darstellung a) erkennt man in der Fig. 11, dass durch die hohe Spannung zu Beginn, also während des Abschnitts T1 Vₒᵤₜ₁ bereits nach nur 5 Nanosekunden den nominalen Spannungswert von 3,3 Volt annimmt. Das heißt gegenüber dem konstanten Einkoppeln eines Spannungssignals Vₑₓ₁ reduziert sich die Zeit bis zum Annehmen eines stationären Zustands deutlich. Das bedeutet, dass auch schneller die akkumulierte Messladung erfasst werden kann.

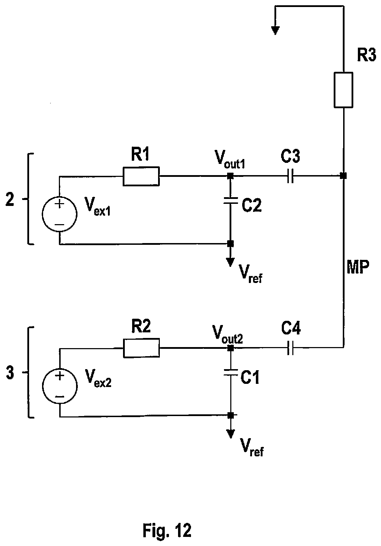

In der Fig. 12 ist ein stark vereinfachtes Ersatzschaltbild für eine dritte Ausführungsform einer Sensoranordnung schematisch dargestellt. Es ist die erste Sensoreinrichtung 2 mit einer Sensorkapazität C2 und eine Zweite 3 mit der Sensorkapazität C1 angedeutet. Als Leitungswiderstände sind Widerstände R1 und R2 angedeutet. Die Widerstände R1, R2 betragen beispielsweise 10 Kiloohm. Die Kapazitäten C3 und C4 sind über einen großen Widerstand R3, der beispielsweise 10 Megaohm beträgt, an Masse gekoppelt. Es wird jeweils der Leitungsknoten mit Vₒᵤₜ₁ und Vₒᵤₜ₂ bezeichnet, an dem die jeweilige Spannung abgreifbar ist.

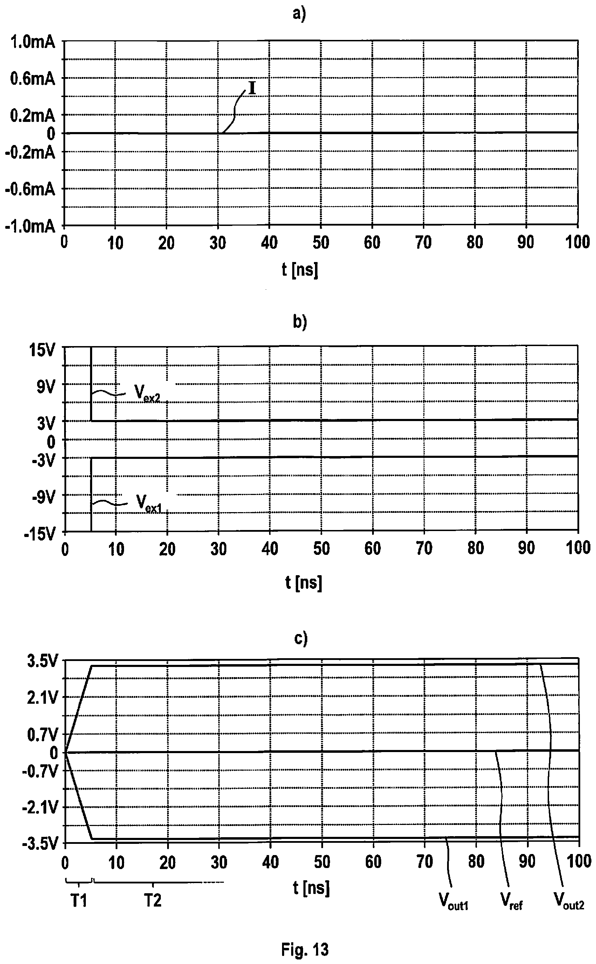

Die Fig. 13 zeigt den zeitlichen Verlauf des über den Widerstand R3 fließenden Stroms I (obere Darstellung a)). Das mittlere Diagramm b) zeigt zwei balancierte Anregungssignale Vₑₓ₁ und Vₑₓ₂, die invers zueinander sind. Im ersten Zeitabschnitt T1 sind die Signale übersteuert, wie es in der Fig. 11 bereits angedeutet ist. Dadurch ergeben sich die in dem unteren Diagramm c) dargestellten Spannungsverläufe an den Leitungsknoten für Vₒᵤₜ₁ und Vₒᵤₜ₂. Man erkennt einerseits die Überschwingung im Zeitbereich T1 der Anregungsperiode die in der Fig. 13 etwa 100 Nanosekunden beträgt und andererseits die balancierte Einkopplung von Anregungssignalen. Im Fall der Fig. 13 sind die Anregungssignale Vₑₓ₁, Vₑₓ₂ für die beiden nur äußerst schematisch dargestellten Sensoreinrichtungen 2,3 invers zueinander.

Es kann bei einem Verfahren zum Betreiben einer entsprechenden Sensoranordnung, insbesondere eine Steuerung der Anregungssignale so erfolgen, dass ein gegenüber der Nominalspannung erhöhter Spannungswert für das Anregungssignal nur solange angelegt wird bis ausgangsseitig am jeweiligen Kondensator die Nominalspannung als Messspannung Vₒᵤₜ₁, Vₒᵤₜ₂ erreicht wird. Das heißt, der jeweilige Kondensator wird solange mit der zu messenden Messladung aufgeladen bis Vₒᵤₜ₁ und Vₒᵤₜ₂ bei 3,3 Volt liegen. Dadurch kann die Frequenz, mit der eine jeweilige Sensoreinrichtung ausgelesen wird, deutlich erhöht werden.

Insgesamt kann durch die vorgeschlagenen Maßnahmen eine Zeitkonstante, die sich aus parasitären Kapazitäten oder Widerständen ergibt und eine Auslesefrequenz begrenzt, deutlich vermindert werden. Die Maßnahmen schaffen ferner einen verbesserten Betrieb von lithographischen Anlagen, bei denen mittels Aktoren optische Elemente bewegt werden müssen. Deren Position kann durch die hier dargestellten Sensoranordnungen schnell und aufwandsgünstig ermittelt werden, so dass eine Ansteuerung der Aktoren ebenfalls verbessert wird. Es ergibt sich damit ein zeitlich effizienterer Regelkreis zur Positionierung von optischen Elementen mit Hilfe von kapazitiven Sensoren und Aktoren.

### BEZUGSZEICHENLISTE

- 1: Sensoranordnung
- 2, 3: kapazitive Sensoreinrichtung
- 4,5: Ausleseeinrichtung
- 6, 7: Operationsverstärker
- 8: Steuereinrichtung
- 9: Leitungsknoten
- 10: Sensoranordnung
- 11, 12: differenzielle kapazitive Sensoreinrichtung
- 13: Basiselement
- 14: Strukturelement
- 15: Lagereinrichtung
- 16: Auswertelektronik
- 17: Kontakte
- 18, 19: Kondensatorelement (ortsfest)
- 20: Kondensatorelement (beweglich)
- 21: Analog-Digital-Wandler
- 22: Referenzpotenzialgenerator
- 23: differenzielle Operationsverstärker
- 24: differenzielle Ausleseeinrichtung
- 25: Steuereinrichtung
- 26: Zuleitungen
- 27: Ausgleichspfad
- 28, 29: Kondensatorelement (ortsfest)
- 30: Kondensatorelement (beweglich)
- 31: differenzielle Ausleseeinrichtung
- 100: Lithographieanlage
- 100A: EUV-Lithographieanlage
- 102: Strahlformungs- und Beleuchtungssystem
- 104: Projektionssystem
- 106A: Strahlungsquelle, EUV-Lichtquelle
- 108A: EUV-Strahlung
- 110: Spiegel
- 112: Spiegel
- 114: Spiegel
- 116: Spiegel
- 118: Spiegel
- 120: Photomaske
- 122: Wafer
- 124: optische Achse des Projektionssystems
- 136: Spiegel
- M1-M6: Spiegel
- 137: Vakuum-Gehäuse

- Ci: Integrationskondensator
- C_{CS1}: Sensorkapazität
- C_{LS1}, C_{RS1}: parasitäre Kapazität
- C_{CS1}: Sensorkapazität
- C_{LS2}, C_{RS2}: parasitäre Kapazität
- C_{CS3}: Sensorkapazität
- C_{LS3}, C_{RS3}: parasitäre Kapazität
- C_{CS4}: Sensorkapazität
- C_{LS4}, C_{RS4}: parasitäre Kapazität
- Cₚ₁, _{pad}: Kapazität
- F1 - F10: Fehlerkurven
- GND: Masse
- MP: Spiegelplatte
- R_{p1,MP}: Widerstand
- R_{p1,wire}: Widerstand
- R_{p1,pad}: Widerstand
- R₁,R₂,R₃: Widerstand
- S₁, S₂: Schalter
- Vbias: Offset-Potenzial
- Vₑₓ₁, Vₑₓ₂: Anregungssignal
- Vdₒᵤₜ₁: Auslesesignal
- Vdₒᵤₜ₂: Auslesesignal
- VSS: Referenzpotenzial
- V_{ref}: Referenzpotenzial
- Vₑₓ: Anregungssignal
- Vₑₓₙₒᵣₘ: nominelles Anregungssignal
- Vₒᵤₜ₁, Vₒᵤₜ₂: Kondensatorspannung

## Patentansprüche

1. Sensoranordnung (1) zum Erfassen einer Lage eines optischen Elements in einer Lithographieanlage, wobei die Sensoranordnung (1) umfasst:
eine erste kapazitive Sensoreinrichtung (2), welche eine lageabhängige veränderbare erste Sensorkapazität (C_{CS1}) hat, welche mit Hilfe eines ersten Anregungssignals (Vₑₓ₁) erfassbar ist;
eine zweite kapazitive Sensoreinrichtung (3), welche eine lageabhänge veränderbare zweite Sensorkapazität (C_{CS2}) hat, welche mit Hilfe eines zweiten Anregungssignals (Vₑₓ₂) erfassbar ist;
eine der ersten Sensoreinrichtung (2) zugeordnete erste Ausleseeinrichtung (4);
eine der zweiten Sensoreinrichtung (3) zugeordnete zweite Ausleseeinrichtung (5); und
mit einer Steuereinrichtung (8), welche eingerichtet ist, das erste und das zweite Anregungssignal (Vₑₓ₁, Vₑₓ₂) derart zu erzeugen, dass sich Ladungen, welche an einer der ersten Sensoreinrichtung (2) zuordenbaren parasitären Kapazität vorliegen, mit Ladungen, welche an einer der der zweiten Sensoreinrichtung (3) zuordenbaren parasitären Kapazität vorliegen, über einen Signalpfad außerhalb des ersten und/oder des zweiten Anregungssignalpfads wenigstens teilweise kompensieren.

2. Sensoranordnung nach Anspruch 1, wobei das erste und das zweite Anregungssignal (Vₑₓ₁, Vₑₓ₂), insbesondere bezüglich eines Offset-Potenzial (V_{bias}), invers zueinander sind.

3. Sensoranordnung nach Anspruch 1 oder 2, wobei das erste und/oder das zweite Anregungssignal (Vₑₓ₁, Vₑₓ₂) ein Wechselspannungssignal, insbesondere ein Rechtecksignal, ist.

4. Sensoranordnung nach einem der Ansprüche 1-3, wobei das erste und/oder das zweite Anregungssignal (Vₑₓ₁, Vₑₓ₂) ein Spannungssignal (Vₑₓ) mit einem vorgegebenen Nominalspannungsverlauf (Vₑₓₙₒᵣₘ) über einen vorgegebenen Anregungszeitraum ist.

5. Sensoranordnung nach Anspruch 4, wobei eine Amplitude des Spannungssignals (Vₑₓ) in einem ersten Anregungsabschnitt (T1) des Anregungszeitraums größer ist als die dem Nominalspannungsverlauf entsprechende Nominalamplitude (Vₑₓₙₒᵣₘ) eingestellt.

6. Sensoranordnung nach Anspruch 5, wobei die Amplitude des Spannungssignals in einem zweiten Anregungsabschnitt (T2) der Nominalamplitude (Vₑₓₙₒᵣₘ) entspricht, und der erste und der zweite Anregungsabschnitt (T1, T2) den Anregungszeitraum bilden.

7. Sensoranordnung nach einem der Ansprüche 4 - 6, wobei zwischen aufeinanderfolgenden Anregungszeiträumen über einen vorgegebenen Pausenzeitraum das erste und/oder das zweite Anregungssignal einem Referenzpotenzial (V_{red} entspricht.

8. Sensoranordnung nach einem der Ansprüche 1 - 7, wobei eine Amplitude des ersten und des zweiten Anregungssignals (Vₑₓ₁, Vₑₓ₂) in Abhängigkeit von erfassten parasitären Kapazitäten eingestellt ist.

9. Sensoranordnung nach einem der Ansprüche 1 - 8, ferner mit einem Basiselement (13), einem Strukturelement (14) zum Halten eines optischen Elements und einem Lagerelement (15) zum beweglichen Lagern des Strukturelements (14) an dem Basiselement (13).

10. Sensoranordnung nach einem der Ansprüche 1 - 9, wobei die erste und/oder die zweite Sensoreinrichtung (11) wenigstens ein erstes und ein zweites Kondensatorelement (18, 19), welche relativ zueinander ortsfest sind, und ein relativ zu dem ersten und zweiten Kondensatorelement (18, 19) bewegliches drittes Kondensatorelement (20) umfasst, wobei in Abhängigkeit von einer Stellung der Kondensatorelemente (18, 19, 20) zueinander die Sensorkapazität (C_{CS1}) zwischen dem ersten und dem zweiten Kondensatorelement (18, 19) auftritt, welche mit Hilfe des über Zuleitungen (26) an das erste und das zweite Kondensatorelement (18, 19) einkoppelbare Anregungssignals (Vₑₓ₁) erfassbar ist.

11. Sensoranordnung nach Anspruch 9 und 10, wobei das erste und das zweite Kondensatorelement (18, 19) an dem Basiselement (13) und das dritte Kondensatorelement (20) an dem Strukturelement (14) angeordnet sind.

12. Sensoranordnung nach einem der Ansprüche 9 - 11, wobei die erste und die zweite Sensoreinrichtung (11, 12) differenziell ausgeführt sind, und wobei die Sensoreinrichtungen (11, 12) zum Erfassen von zwei verschiedenen Kippbewegung angeordnet sind.

13. Sensoranordnung nach einem der Ansprüche 9 - 12 und Anspruch 10, wobei die ersten und zweiten Kondensatorelemente (18, 19) einzeln mit Hilfe von Zuleitungen in oder an dem Basiselement (13) kontaktierbar sind, und die dritten Kondensatorelemente (20) über das Strukturelement (14) elektrisch miteinander gekoppelt sind.

14. Lithographieanlage (100) mit wenigstens einem optischen Element und einer Sensoreinrichtung (1, 10) nach einem der Ansprüche 1-13 zum Erfassen einer Lage des optischen Elements.

15. Verfahren zum Betreiben einer Lithographieanlage (100) nach Anspruch 14, mit den Schritten:
Erzeugen des ersten und des zweiten Anregungssignals (Vₑₓ₁, Vₑₓ₂) derart, dass sich Ladungen, welche an der der ersten Sensoreinrichtung (2) zuordenbaren parasitären Kapazität vorliegen, mit Ladungen, welcher an der der zweiten Sensoreinrichtung (3) zuordenbaren parasitären Kapazität vorliegen, über einen Signalpfad außerhalb des ersten und/oder des zweiten Anregungssignalpfads wenigstens teilweise kompensieren;
Erfassen der ersten und der zweiten Sensorkapazität (C_{CS1}, C_{CS2}); und
Bestimmen einer Neigung oder Lage des optischen Elements in Abhängigkeit von der erfassten ersten und zweiten Sensorkapazität (C_{CS1}, C_{CS2}).

## Claims

1. Sensor arrangement (1) for sensing a position of an optical element in a lithography system, wherein the sensor arrangement (1) comprises:
a first capacitive sensor device (2) that has a position-dependent variable first sensor capacitance (C_{CS1}) that can be sensed using a first excitation signal (Vexl);
a second capacitive sensor device (3) that has a position-dependent variable second sensor capacitance (C_{CS2}) that can be sensed using a second excitation signal (Vₑₓ₂);
a first reading device (4) associated with the first sensor device (2);
a second reading device (5) associated with the second sensor device (3); and
having a control device (8) that is set up to produce the first and second excitation signals (Vₑₓ₁, Vₑₓ₂) such that charges that are present on a parasitic capacitance associable with the first sensor device (2) are at least partially compensated for by charges that are present on a parasitic capacitance associable with the second sensor device (3) via a signal path outside the first and/or the second excitation signal path.

2. Sensor arrangement according to Claim 1, wherein the first and second excitation signals (Vₑₓ₁, Vₑₓ₂) are the inverse of one another, in particular with regard to an offset potential (V_{bias}).

3. Sensor arrangement according to Claim 1 or 2, wherein the first and/or the second excitation signal (Vₑₓ₁, Vₑₓ₂) is an AC voltage signal, in particular a square-wave signal.

4. Sensor arrangement according to one of Claims 1-3, wherein the first and/or the second excitation signal (Vₑₓ₁, Vₑₓ₂) is a voltage signal (Vₑₓ) having a prescribed nominal voltage characteristic (Vₑₓₙₒᵣₘ) over a prescribed excitation period.

5. Sensor arrangement according to Claim 4, wherein an amplitude of the voltage signal (Vₑₓ) in a first excitation section (T1) of the excitation period is set to be greater than the nominal amplitude (Vₑₓₙₒᵣₘ) corresponding to the nominal voltage characteristic.

6. Sensor arrangement according to Claim 5, wherein the amplitude of the voltage signal in a second excitation section (T2) corresponds to the nominal amplitude (Vₑₓₙₒᵣₘ), and the first and second excitation sections (T1, T2) form the excitation period.

7. Sensor arrangement according to one of Claims 4-6, wherein the first and/or the second excitation signal corresponds to a reference potential (V_{ref}) between successive excitation periods over a prescribed pause period.

8. Sensor arrangement according to one of Claims 1-7, wherein an amplitude of the first and second excitation signals (Vₑₓ₁, Vₑₓ₂) is set on the basis of sensed parasitic capacitances.

9. Sensor arrangement according to one of Claims 1-8, further having a base element (13), a structural element (14) for retaining an optical element and a bearing element (15) for movably supporting the structural element (14) on the base element (13).

10. Sensor arrangement according to one of Claims 1-9, wherein the first and/or the second sensor device (11) comprises at least a first and a second capacitor element (18, 19), which are fixed relative to one another, and a third capacitor element (20) that is movable relative to the first and second capacitor elements (18, 19), the sensor capacitance (C_{CS1}) appearing between the first and second capacitor elements (18, 19) on the basis of a position of the capacitor elements (18, 19, 20) in relation to one another, said sensor capacitance being able to be sensed using the excitation signal (Vₑₓ₁), which can be coupled to the first and second capacitor elements (18, 19) via supply lines (26).

11. Sensor arrangement according to Claims 9 and 10, wherein the first and second capacitor elements (18, 19) are arranged on the base element (13) and the third capacitor element (20) is arranged on the structural element (14).

12. Sensor arrangement according to one of Claims 9 - 11, wherein the first and second sensor devices (11, 12) are embodied in differential fashion, and wherein the sensor devices (11, 12) are arranged to sense two different tilt movements.

13. Sensor arrangement according to one of Claims 9-12 and Claim 10, wherein the first and second capacitor elements (18, 19) are individually contactable using supply lines in or on the base element (13), and the third capacitor elements (20) are electrically coupled to one another via the structural element (14).

14. Lithography system (100) having at least one optical element and a sensor device (1, 10) according to one of Claims 1-13 for sensing a position of the optical element.

15. Method for operating a lithography system (100) according to Claim 14, having the steps of:
producing the first and second excitation signals (Vₑₓ₁, Vₑₓ₂) such that charges that are present on the parasitic capacitance associable with the first sensor device (2) are at least partially compensated for by charges that are present on the parasitic capacitance associable with the second sensor device (3) via a signal path outside the first and/or the second excitation signal path;
sensing the first and second sensor capacitances (C_{CS1}, C_{CS2}); and
determining an inclination or position of the optical element on the basis of the sensed first and second sensor capacitances (C_{CS1}, C_{CS2}).

## Revendications

1. Arrangement capteur (1) destiné à détecter une position d'un élément optique dans une installation de lithographie, l'arrangement capteur (1) comprenant :
un premier dispositif capteur capacitif (2), qui possède une première capacité de capteur (Ccsi) variable en fonction de la position, laquelle peut être détectée à l'aide d'un premier signal d'excitation (Vₑₓᵢ) ;
un deuxième dispositif capteur capacitif (3), qui possède une deuxième capacité de capteur (C_{CS2}) variable en fonction de la position, laquelle peut être détectée à l'aide d'un deuxième signal d'excitation (Vₑₓ₂) ;
un premier dispositif de lecture (4) associé au premier dispositif capteur (2) ;
un deuxième dispositif de lecture (5) associé au deuxième dispositif capteur (3) ; et
comprenant un dispositif de commande (8), qui est conçu pour générer le premier et le deuxième signal d'excitation (Vₑₓ₁, Vₑₓ₂) de telle sorte que les charges qui sont présentes au niveau d'une capacité parasite associable au premier dispositif capteur (2) sont compensées par les charges qui sont présentes au niveau de la capacité parasite associable au deuxième dispositif capteur (3), au moins partiellement par le biais d'un trajet de signal en-dehors du premier et/ou du deuxième trajet de signal d'excitation.

2. Arrangement capteur selon la revendication 1, le premier et le deuxième signal d'excitation (Vₑₓ₁, Vₑₓ₂) étant inverses l'un par rapport à l'autre, notamment pour ce qui concerne un potentiel de décalage (V_{bias}).

3. Arrangement capteur selon la revendication 1 ou 2, le premier et/ou le deuxième signal d'excitation (Vₑₓ₁, Vₑₓ₂) étant un signal de tension alternative, notamment un signal rectangulaire.

4. Arrangement capteur selon l'une des revendications 1 à 3, le premier et/ou le deuxième signal d'excitation (Vₑₓ₁, Vₑₓ₂) étant un signal de tension (Vₑₓ) ayant un tracé de tension nominale (Vₑₓₙₒᵣₘ) prédéfini sur une période d'excitation prédéfinie.

5. Arrangement capteur selon la revendication 4, une amplitude du signal de tension (Vₑₓ) dans une première portion d'excitation (T1) de la période d'excitation étant supérieure à l'amplitude nominale (Vₑₓₙₒᵣₘ) réglée correspondant au tracé de tension nominale.

6. Arrangement capteur selon la revendication 5, l'amplitude du signal de tension dans une deuxième portion d'excitation (T2) correspondant à l'amplitude nominale (Vₑₓₙₒᵣₘ), et la première et la deuxième portion d'excitation (T1, T2) formant la période d'excitation.

7. Arrangement capteur selon l'une des revendications 4 à 6, le premier et/ou le deuxième signal d'excitation correspondant à un potentiel de référence (V_{ref}) sur une période de pause prédéfinie entre des périodes d'excitation successives.

8. Arrangement capteur selon l'une des revendications 1 à 7, une amplitude du premier et du deuxième signal d'excitation (Vₑₓ₁, Vₑₓ₂) étant réglée en fonction des capacités parasites détectées.

9. Arrangement capteur selon l'une des revendications 1 à 8, comprenant en outre un élément de base (13), un élément structural (14) destiné à maintenir un élément optique et un élément support (15) destiné à supporter avec mobilité l'élément structural (14) sur l'élément de base (13).

10. Arrangement capteur selon l'une des revendications 1 à 9, le premier et/ou le deuxième dispositif capteur (11) comportant au moins un premier et un deuxième élément condensateur (18, 19), qui sont fixes l'un par rapport à l'autre, et un troisième élément condensateur (20) mobile par rapport au premier et au deuxième élément condensateur (18, 19), la capacité de capteur (Ccsi) entre le premier et le deuxième élément condensateur (18, 19), laquelle peut être détectée à l'aide du signal d'excitation (Vₑₓᵢ) injectable au niveau du premier et du deuxième élément condensateur (18, 19) par le biais de lignes d'arrivée (26), apparaissant en fonction d'une position des éléments condensateurs (18, 19, 20) les uns par rapport aux autres.

11. Arrangement capteur selon les revendications 9 et 10, le premier et le deuxième élément condensateur (18, 19) étant disposés sur l'élément de base (13) et le troisième élément condensateur (20) sur l'élément structural (14).

12. Arrangement capteur selon l'une des revendications 9 à 11, le premier et le deuxième dispositif capteur (11, 12) étant de configuration différentielle, et les dispositifs capteurs (11, 12) étant disposés pour détecter deux mouvements de basculement différents.

13. Arrangement capteur selon l'une des revendications 9 à 12 et la revendication 10, un contact avec les premier et deuxième éléments condensateurs (18, 19) pouvant être établi individuellement à l'aide de lignes d'arrivée dans ou sur l'élément de base (13), et les troisièmes éléments condensateurs (20) étant connectés électriquement entre eux par le biais de l'élément structural (14).

14. Installation de lithographie (100) comprenant au moins un élément optique et un arrangement capteur (1, 10) selon l'une des revendications 1 à 13 servant à détecter une position de l'élément optique.

15. Procédé pour faire fonctionner une installation de lithographie (100) selon la revendication 14, comprenant les étapes suivantes :
génération du premier et du deuxième signal d'excitation (Vₑₓ₁, Vₑₓ₂) de telle sorte que les charges qui sont présentes au niveau de la capacité parasite associable au premier dispositif capteur (2) sont compensées par les charges qui sont présentes au niveau de la capacité parasite associable au deuxième dispositif capteur (3), au moins partiellement par le biais d'un trajet de signal en-dehors du premier et/ou du deuxième trajet de signal d'excitation ;
détection de la première et de la deuxième capacité de capteur (Ccsi, C_{CS2}) ; et
détermination d'une inclinaison ou d'une position de l'élément optique en fonction de la première et de la deuxième capacité de capteur (Ccsi, C_{CS2}) détectées.
